# DEMANDE DE BREVET EUROPEEN

(11) **EP 0 851 512 A1**
(43) Date de publication de la demande: **01.07.1998**
(21) Numéro de dépôt: 97403106.4
(22) Date de dépôt: 19.12.1997
(51) Int. Cl.: H01L 31/115

(54) **Dispositif de détection de rayonnements ionisants a semi-conducteur de haute résistivité**

(30) Priorité: 24.12.1996 FR 9615940
(71) Demandeur: COMMISSARIAT A L'ENERGIE ATOMIQUE, 75015 Paris (FR)
(72) Inventeur: Verger, Loick, 38000 Grenoble (FR); Rosaz, Murali, 75019 Paris (FR); Rustique, Jacques, 38170 Seyssinet (FR); Sanchez, Gérard, 38000 Grenoble (FR)
(74) Mandataire: Dubois-Chabert, Guy

(57) **Abrégé**

La présente invention concerne un dispositif de détection de rayonnement ionisant de faible et forte énergie constitué d'un matériau semiconducteur muni d'une cathode, d'une anode et d'au moins une grille, permettant d'obtenir un détecteur de rayonnement à très haute résolution en énergie fonctionnant à température ambiante.

## Description

### Domaine technique

La présente invention concerne un dispositif de détection de rayonnements ionisants à base de semi-conducteur de haute résistivité à haute résolution en énergie (20 à quelques Mev).

### Etat de la technique antérieure

De nombreux types de détecteurs on été imaginés pour la détection de rayonnements X ou y. L'emploi de détecteurs solides à base de semi-conducteurs a été le principal apport de ces trente dernières années aux techniques de détection du rayonnement X ou γ, qui utilisent majoritairement les détecteurs à gaz ou à scintillation.

Les détecteurs à base de semi-conducteurs réalisent directement la conversion en énergie du rayonnement X ou γ dans la matière sans passer par des étapes intermédiaires telles que l'émission de photons visibles dans le cas des scintillateurs. On s'affranchit ainsi des problèmes de couplage synonymes de perte de rendement. L'énergie nécessaire pour créer une paire électron-trou dans un semi-conducteur est beaucoup plus faible que dans un gaz ou dans un scintillateur (environ 4 eV dans les semi-conducteurs contre 30 eV dans les gaz et 300 eV dans les systèmes scintillateurs photomultiplicateurs). En conséquence, le nombre de charges libres créées par photon détecté est plus important, ce qui permet d'obtenir de meilleures résolutions en énergie avec un faible bruit. De plus, leur numéro atomique et leur densité élevés permettent d'utiliser des volumes de détection nettement inférieurs à cause du gaz ou des scintillateurs tout en conservant la même efficacité quantique de détection (voir document référencé [1] en fin de description).

L'ensemble de ces avantages ont permis d'utiliser les détecteurs à base de semi-conducteurs dans les trois domaines d'application suivants (voir document référencé [2]) :
- la détection nucléaire dont l'objectif est de mesurer l'énergie déposée par un photon γ issu d'une source de rayonnement nucléaire ;
- la détection de rayonnement X dont l'objectif est de réaliser l'image radiologique d'un objet irradié par un générateur à rayons X ;
- l'instrumentation scientifique, dès lors qu'il faut détecter des impulsions de rayonnement X brèves et en mesurer l'évolution temporelle et l'intensité.

L'utilisation de matériaux semi-conducteurs comme détecteurs de rayonnement X ou γ implique le dépôt de deux contacts électriques à la surface du matériau aux bornes desquelles une tension de polarisation est appliquée. Les porteurs de charges, c'est-à-dire les paires électron-trou, créées par l'interaction du photon γ avec le matériau, se séparent sous l'action du champ électrique, les électrons migrant vers l'électrode positive et les trous vers l'électrode négative. L'aptitude de ces porteurs de charge à migrer vers les électrodes sans se faire piéger par des défauts présents dans le matériau semi-conducteur conditionne la résolution en énergie du spectre mesuré (en détection γ) ou le signal mesuré (en détection X). Cette aptitude appelée aussi « propriétés de transport des porteurs de charge » est mesurée par la mobilité et la durée de vie des électrons et des trous (voir article référencé [3]).

Aujourd'hui les performances des détecteurs γ sont limitées par la présence de défauts natifs dans les semi-conducteurs qui, en piégeant les porteurs de charge durant leur migration vers les électrodes, diminuent leur durée de vie et, ainsi, détériorent la résolution en énergie du détecteur. L'influence de ces défauts sur le piégeage des porteurs de charge est d'autant plus grande que le détecteur est épais et donc utilisé à haute énergie (> 100 Kev). Ces défauts natifs apparaissent systématiquement durant la cristallogénèse du matériau semi-conducteur. La bibliographie portant sur l'étude de ces défauts est abondante et elle montre que la cristallogénèse de tous les semi-conducteurs de haute résistivité, pouvant fonctionner à température ambiante, n'est pas maîtrisée au point de supprimer ces défauts (voir article référencé [4]).

Il existe plusieurs moyens de compenser le piégeage des porteurs de charge durant leur migration (voir article référencé [1]) :
- Utiliser des structures diodes qui, par une diminution du courant d'obscurité d'un facteur 10 environ, permettent d'appliquer un fort champ électrique et ainsi limiter le piégeage des porteurs libres. Néanmoins, l'amélioration des performances du détecteur n'est visible que pour des faibles épaisseurs. De plus, certains semi-conducteurs comme le CdTe présentent un effet de polarisation (diminution du signal dans le temps) qui rend les structures diodes inutilisables. Même si cet effet peut être éliminé en faisant fonctionner la diode CdTe à faible température (voir article référencé [5]), la mise en oeuvre est assez lourde.
- Sélectionner les interactions des photons avec la matière pour lesquelles le piégeage des porteurs est limité. Cela revient à sélectionner les interactions proches de l'électrode irradiée pour lesquelles le signal électron est prédominant. Les propriétés de transport des électrons étant nettement supérieures à celles des trous, on obtient une très bonne résolution en énergie. Malheureusement, cela est au détriment de l'efficacité quantique de détection du détecteur puisque cette sélection élimine les interactions se produisant loin de l'électrode irradiée. On limite donc électroniquement l'épaisseur utile du détecteur.
- Compenser les mauvaises propriétés de transport des trous par la mesure de la relation qui existe entre l'amplitude du signal intégré de chaque interaction et leur temps de montée. Cette nouvelle méthode montre que cette relation est linéaire pour certains détecteurs CdTe, ce qui permet de corriger les « coups » mal collectés qui correspondent à des amplitudes faibles et des temps de montée longs (voir article référencé [6]). Il semble que c'est aujourd'hui la seule méthode permettant d'obtenir des détecteurs y à base de CdTe avec une bonne résolution en énergie et une bonne efficacité quantique de détection. Malheureusement, elle ne fonctionne pas quel que soit le type de matériau CdTe, certaines méthodes de tirage de cristaux ne présentant aucune corrélation amplitude-temps montée, et quel que soit le détecteur CdTe, l'épaisseur étant limitée à 2 nm (au-delà la correction amplitude-temps n'est pas corrigeable) et certaines propriétés physiques du détecteur étant nécessaires (bonnes propriétés de transfert des trous).
- Utiliser des détecteurs hémisphériques, mais ceci est très lourd à mettre en oeuvre.

La présente invention a pour objet une nouvelle structure de détection à base de semi-conducteur de haute résistivité permettant d'obtenir un détecteur γ à très haute résolution en énergie, fonctionnant à température ambiante. Cela suppose que ladite structure parvient à compenser les mauvaises propriétés de transport des porteurs de charges sur des épaisseurs de détecteurs élevées.

Le problème d'efficacité de collection des porteurs de charges n'est pas nouveau et existait déjà pour les gaz. Une des solutions apportées fut la réalisation de grille de Frisch (voir article référencé [7]), dont le principe consiste à insérer entre les deux électrodes une grille transparente avec un potentiel intermédiaire à celui de l'anode et la cathode. Le signal utile du détecteur est mesuré entre le potentiel de l'anode et le potentiel de la grille de Frisch qui est disposée très près de l'anode. Suite à l'irradiation de la cathode par le rayonnement γ, les porteurs de charge sont créés entre la cathode et la grille de Frisch : les électrons migrent facilement vers la grille de Frisch alors que les ions migrent difficilement vers la cathode. Durant la migration des porteurs de charge, aucun signal n'est mesuré à l'anode car le potentiel de la grille de Frisch fait écran électrostatique. Un signal est mesuré, correspondant à la migration des électrons entre la grille de Frisch et l'anode, seulement lorsque les électrons traversent cette grille. Les propriétés de transport des électrons étant excellentes, aucun électron n'est piégé durant sa migration entre son lieu d'interaction et la grille de Frisch. Un éventuel piégeage pourrait être corrigé par l'adjonction d'un gain variable au niveau du préamplificateur de charge à l'anode. En conséquence, le signal mesuré à l'anode ne dépend pas du lieu d'interaction du photon entre la cathode et la grille de Frisch. La composante du signal ionique a été ainsi éliminée.

Pour augmenter l'efficacité de collection des porteurs, les détecteurs à semi-conducteur de l'art antérieur comportent des électrodes en peignes interdigités permettant d'obtenir un effet de grille de Frisch. Ces dispositifs nécessitent deux préamplificateurs par pixel compliquant la conception électronique d'un imageur gamma et engendrant des problèmes technologiques (résistivité entre électrodes sur la même surface).

Dans un exemple de réalisation de telles structures à semi-conducteur peuvent comporter des peignes interdigités appelés « structures coplanaires Frisch Strip (CFS) », l'appellation mode commun ou mode strip faisant référence à l'électronique d'acquisition.

Pour les détecteurs semi-conducteurs, P.N. Luke (voir article référencé [8]) propose la réalisation d'une structure s'inspirant des grilles de Frisch pour le semi-conducteur CdTe. Elle consiste à déposer des contacts classiques (évaporation d'or ou de platine), pleine face pour la cathode (électrode irradiée) et sous forme de bande pour l'anode. La moitié des bandes sont reliées entre elles avec un potentiel plus faible que celui de l'autre moitié, également reliées entre elles. Chacun de ces deux potentiels est relié à un préamplificateur de charge où est intégrée la charge issue de la migration des électrons vers l'anode. Celle-ci est identique sur les deux préamplificateurs tant que les électrons n'atteignent pas l'anode. Par contre, du fait de la différence entre les deux potentiels de l'anode, la charge intégrée sur chaque préamplificateur est différente lorsque les électrons sont très près de l'anode. Cette astuce géométrique permet, par différence des deux signaux intégrés sur les deux préamplificateurs, de rendre cette différence (signal utile) indépendante du lieu d'interaction des photons, puisque cette différence n'apparaît que lorsque les électrons sont très près de l'anode. Les résultats obtenus sont assez remarquables. Néanmoins, cette méthode présente l'inconvénient d'imposer deux préamplificateurs par pixel, ce qui, pour la réalisation d'un imageur γ composé de milliers de pixels, apparaît très lourd dans la conception de l'électronique, d'être sensible à l'état de surface de l'anode (qualité du polissage), la zone sensible étant proche de l'anode, et d'engendrer des problèmess technologiques, la résistance entre les peignes devant être élevée.

L'invention a pour objet de réaliser une telle structure de détection à grille de Frisch adaptée aux semi-conducteurs.

### Exposé de l'invention

L'invention propose un dispositif de détection de rayonnement ionisant comportant un bloc de matériau semi-conducteur de haute résistivité apte à détecter un signal électrique obtenu par l'interaction du rayonnement incident avec le matériau semi-conducteur, muni d'une cathode portée à un premier potentiel et d'une anode portée à un second potentiel, caractérisé en ce qu'il est muni d'au moins une grille située entre la cathode et l'anode, cette grille étant polarisée à un troisième potentiel supérieur au premier potentiel et peu inférieur au second de façon à ce que le signal généré entre la grille et l'anode soit indépendant du lieu d'interaction du photon avec le matériau semi-conducteur, et en ce que la grille de Frisch ainsi composée est formée d'un seul bloc sans la réalisation de géométrie de contacts spécifiques ou de dépôts de diodes.

Dans une première variante de réalisation la (ou les) grilles, métalliques, sont obtenues après insertion dans le creuset avant la cristallogénèse des semi-conducteurs, cette (ou ces) grille(s) se trouvant ainsi intégrée(s) dans le lingot avant sa croissance, une découpe spécifique du lingot en détecteurs et le dépôt de contact classique de part et d'autre des faces du détecteur permettant de réaliser une vraie grille de Frisch.

Dans une seconde variante, cette grille est réalisée par la formation d'un peigne dont les parties supérieures sont portées au second potentiel et les parties inférieures au troisième potentiel. Une structure dentée est réalisée sur une des faces du bloc de matériau semi-conducteur. Les lignes de contact, polarisées au troisième potentiel, constituent un écran électrostatique aux lignes de contact polarisées au second potentiel lorsque les charges migrent de la cathode à la grille. Le signal mesuré correspond à la migration des charges de la grille à l'anode.

L'invention peut s'appliquer à des détecteurs épais (entre deux et dix millimètres) de rayonnements α, β, γ, et X. Pour ces derniers, le débit des photons doit être suffisamment lent pour que le détecteur puisse différencier chaque photon.

La détection nucléaire constitue la principale application de la présente invention mais la détection de rayonnement X et l'instrumentation scientifique, moins sévères dans les propriétés de détection exigées du détecteur, sont néanmoins possibles.

### Brève description des dessins

- Les figures 1A, 1B et 1C illustrent un exemple de dispositif de détection de rayonnement utilisant une grille de Frisch respectivement dans une vue de côté, dans une vue en coupe AA et dans une vue en coupe BB (maillage) ;
- la figure 2 illustre le dispositif de l'invention ;
- la figure 3 illustre la comparaison de la fonction d'écran de la grille de Frisch en mode commun et en mode « strip ».

### Exposé déraillé de réalisation

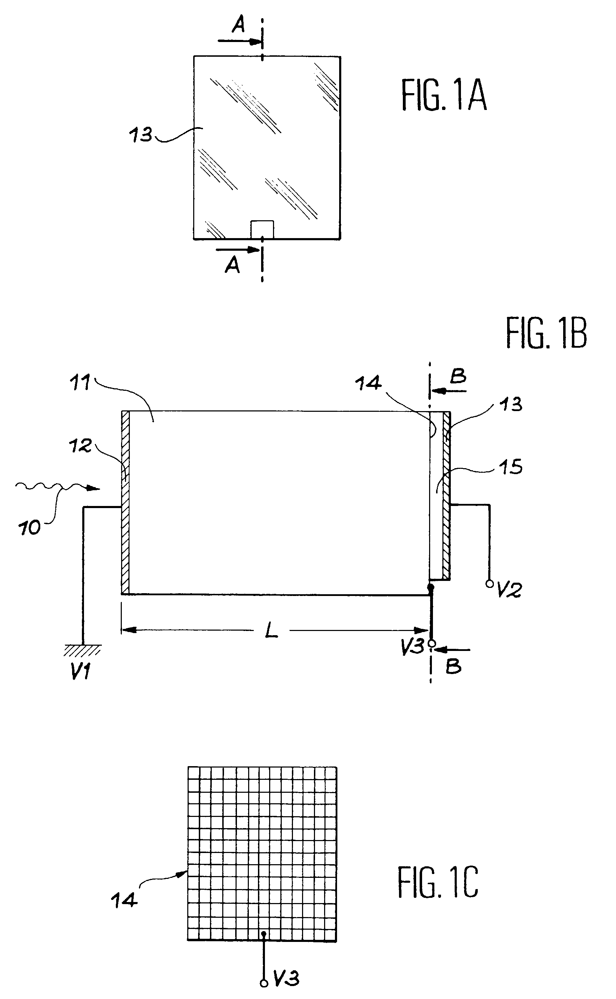

Le dispositif de détection de rayonnement ionisant, illustré sur la figure 1, comporte un bloc de matériau semi-conducteur de haute résistivité apte à détecter un signal électrique obtenu par l'interaction d'un rayonnement incident 10 avec le matériau semi-conducteur 11. Ce dispositif est muni d'une cathode 12 portée à un premier potentiel V1, d'une anode 13 portée à un second potentiel V2, et d'une grille 14 et d'une zone diode 15 située entre la cathode 12 et l'anode 13. Cette grille 14 étant polarisée à un troisième potentiel V3 supérieur à V1 et peu inférieur à V2 de façon à ce que le signal généré entre la grille et l'anode soit indépendant du lieu d'interaction du photon avec le matériau détecteur. On a ainsi V1<<V3<V2 avec V3>0 et V2>0.

Cette technique s'applique à des détecteurs épais (largeur L comprise entre deux et dix millimètres) de rayonnements α, β, γ et X. Pour ces derniers, le débit des photons doit être suffisamment lent pour que le détecteur puisse différencier chaque photon.

Ce dispositif permet de réaliser une grille transparente aux électrons dont le potentiel écrante le signal mesuré à l'anode et de déposer une diode sensible aux électrons sur le matériau semi-conducteur résistif (On appelle « diode » un matériau qui donne un signal quand un électron entre dans l'électrode (détecteur à électron)).

A titre d'exemple, le matériau semi-conducteur est du CdTe dopé chlore (mais tout autre type de CdTe convient), orienté (111) dans le meilleur des cas. Cette orientation (111) permet d'adapter une première face du bloc de matériau semi-conducteur (face B ou blanche révélée à l'acide lactique ou dépôt d'hétérojonction à base d'HgCdTe) . Un contact métallique (or, platine, argent, cuivre, ..) est déposé pleine face et constitue la cathode 12. Une seconde face, opposée à la première, est décapée chimiquement au méthanol bromé par exemple. Une lithographie permet de déposer une grille 14 dont le maillage est optimisé afin de répondre aux compromis de transparence aux passages des électrons, et d'établissement d'un potentiel, mais aussi de qualité de la couche diode 15 à déposer.

Dans la réalisation de la grille, il faut, en effet, faire un compromis :
- si le maillage est fin, la transparence est favorisée au détriment de l'écrantage électrostatique (c'est-à-dire qu'un signal provenant de la migration des électrons peut être détecté) ;
- quand le détecteur est trop fin, les photons traversent sans être convertis en paire électron-trou ; quand le détecteur est trop épais, les électrons peuvent être piégés et on perd en efficacité de collection.

Ce dispositif propose un compromis entre une bonne efficacité de détection (détecteur épais permettant la création de paires électron-trou pour chaque photon incident) et une bonne résolution en énergie (bonne collection des charges). Il propose un détecteur semi-conducteur où l'effet de grille de Frisch est obtenu non pas sur la structure géométrique des électrodes, mais sur la structure géométrique même du matériau détecteur.

Il s'attache à bien distinguer l'effet d'écrantage et la zone utile de détection par un effet géométrique associé au détecteur et non au contact électrique. cela permet d'utiliser au mieux l'effet de la grille de Frisch et d'utiliser un seul préamplificateur par détecteur.

La couche diode 15 est sensible aux électrons et donc peu épaisse (quelques dizaines de micromètres). Cette faible épaisseur va dans le sens d'une meilleure sensibilité. Cette couche peut être une hétérojonction (HgCdTe-n, HgCdTe-p, CdS, ZnS, ... ) ou une jonction (dépôts MBE, EJM, LPE, dépôts par implantation dans le matériau résistif) formée par la courbure de la bande liée aux différences de potentiels des niveaux de Fermi du substrat (CdTe résistif) et de la couche déposée. La très faible épaisseur nécessaire à la détection des électrons ouvre la voie à de nombreuses possibilités de dépôt. Les technologies utilisées dans les capteurs solaires peuvent être appliquées avec profit. Le dépôt d'un contact pleine face sur la diode et adapté à son fonctionnement constitue l'anode 13. On obtient ainsi une structure de détection à base de semi-conducteur avec une grille de Frisch qui permet d'atteindre des performances avec de hautes résolutions en énergie tout en n'utilisant qu'un seul préamplificateur de charge par cellule de détection (pixel). Le principe de fonctionnement est identique à celui du détecteur à gaz muni d'une grille de Frisch. L'épaisseur du détecteur CdTe peut aller jusqu'à six à dix millimètres autorisant ainsi une spectrométrie de haute résolution pour de hautes énergies (∼1 MeV).

Ainsi, afin d'améliorer l'efficacité de détection et la résolution en énergie d'un détecteur semi-conducteur, de nombreux laboratoires proposent la réalisation de grilles de Frisch basées sur la réalisation de géométries de contacts spécifiques (semi-conducteur + géométrie de contacts spécifiques) ou sur le dépôt d'une diode sur une grille préalablement déposée sur le semi-conducteur (semi-conducteur + diodes). L'originalité de la présente invention consiste à réaliser une grille de Frisch composée d'un seul bloc (le semi-conducteur seul) sans la réalisation de géométries de contacts spécifiques ou de dépôt de diodes.

Dans une première variante la présente invention consiste à insérer une ou plusieurs grilles métalliques (par exemple en carbure de silicium) dans le creuset avant la cristallogénèse des semi-conducteurs. Une telle grille dont le maillage est optimisé afin de répondre au compromis transparence-écrantage se trouve ainsi intégrée dans le lingot avant sa croissance (la nature de cette grille doit permettre son utilisation en haute fréquence). Une découpe spécifique du lingot en détecteurs et le dépôt de contact classique de part et d'autre des faces du détecteur permet de réaliser une vraie grille de Frisch, comme illustrée sur la figure 1.

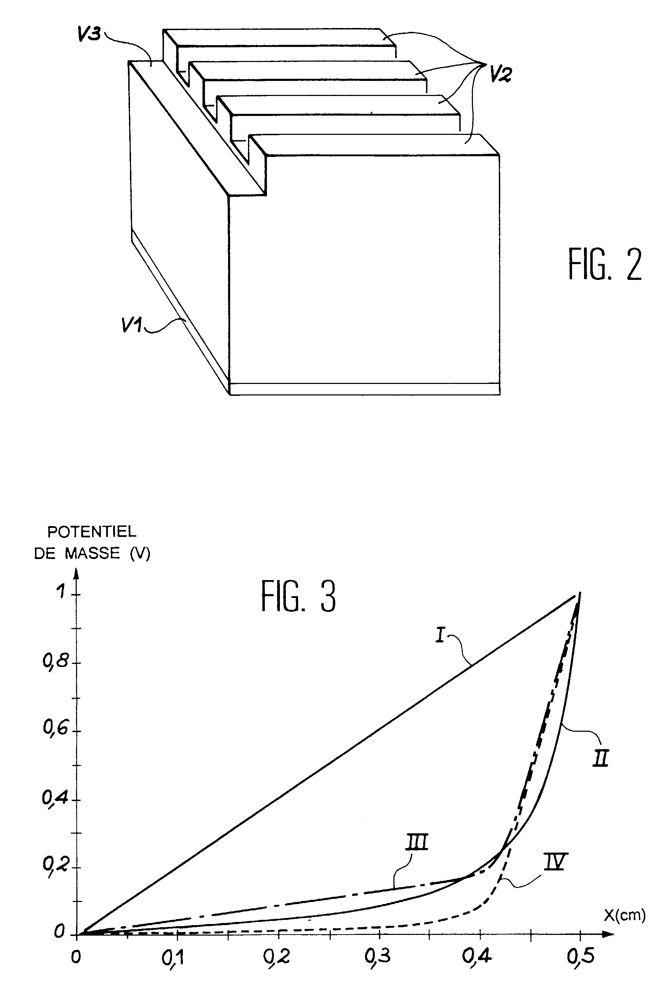

Une seconde variante consiste à réaliser une structure dentée sur une des faces du détecteur CdTe, comme illustré sur la figure 2. La grille 14 peut être réalisée par la formation d'un peigne dont les parties supérieures sont portées au second potentiel V2 et les parties inférieures au troisième potentiel V3. Les lignes de contact polarisées au premier potentiel V1 constituent un écran électrostatique aux lignes de contact polarisées au second potentiel V2 lorsque les charges migrent de la cathode 12 à la grille 14. Le signal mesuré correspond à la migration des charges de la grille 14 à l'anode 13. Si les lignes supérieures sont court-circuitée, la grille de Frisch fonctionne en mode commun. Par de meilleures performances, on peut associer un préamplificateur par ligne (mode strip).

La structure dentée est faite, par exemple, à l'aide d'une machine de découpe à scie diamantée.

Le principe de la grille de Frisch utilisé dans les gaz et appliqué au détecteur à base de semi-conducteur de l'invention est d'autant plus performant en terme d'efficacité de détection et de résolution en énergie du détecteur que l'effet d'écrantage et la zone utile de détection des électrons sont élevés :
- la structure « strip » utilise la géométrie des électrodes afin de créer l'effet d'écrantage et la zone utile de détection. Cette zone dépend du pas et de la largeur de bande du peigne, ce qui limite les possibilités eu égard à la difficulté technologique de réaliser un peigne. De plus, chaque bande doit être associée à un préamplificateur afin d'observer l'effet d'écrantage. A titre d'exemple, il faut huit à seize préamplificateurs par détecteur (un pixel dans un système matriciel) de 4×4×5 mm³ ;
- la structure à peignes interdigités présente elle aussi une zone sensible aux électrons qui dépend du pas et de la largeur des bandes. De plus, le signal utile correspond à la soustraction du signal associé à chaque peigne. Il faut donc deux préamplificateurs par détecteur et le signal résultant (soustraction des deux signaux mesurés par les préamplificateurs) demeure faible avec un rapport signal à bruit médiocre.

La figure 3 illustre la comparaison de la fonction d'écran avec celle de la grille de Frisch dentée d'un détecteur CdTe en mode plan (I), en mode strip SF(II), en mode commun CFDC (III) et en mode strip GFDS (IV), en ayant les dimensions suivantes :

| | |
|---|---|
| Epaisseur = | 5 mm |
| Géométrie = | 5*5 mm² |
| Hauteur dent = | 0,8 mm |
| Wc (largeur de l'électrode collectante (V2)) = | 0,56 mm |
| Wnc (largeur de l'électrode non collectante (V3)) = | 0,04 mm |
| Largeur pixel = | 0,56 mm |
| Ecart interpixel = | 0,04 mm |

### REFERENCES

[1] Article intitulé « Cadmium telluride and related materials as X- and gamma-ray detectors : a review of recent progress » de P. Siffert (SPIE, volume 2305, pages 98 à 109).
[2] Article intitulé « CdTe in photoconductive applications. Fast detector for metrology and X-ray imaging » de Marc Cuzin (Nuclear Instruments and Methods in Physics Research, A 322, 1992, pages 341-351).
[3] Article intitulé « Transport Properties of CdTe » de C. Canali, M. Martini, G. Ottaviani et K.R. Zanio (Physical Review B, volume 4, numéro 2, 15 juillet 1971, pages 422 à 431).
[4] Article intitulé « Structural defects in high resistivity cadmium telluride » de M. Samimi, B. Biglari, M. Hage-Ali, J.M. Koebel et P. Siffert (Nuclear Instruments and Methods in Physics Research, A283, 1989, pages 243 à 248).
[5] Article intitulé « Cadmium telluride detectors with thermoelectric cooling » de A. Kh. Khusainov (Nuclear Instruments and Methods in Physics Research, A322, 1992, pages 335 à 340).
[6] Article intitulé « Pulse processing for planar cadmium telluride detectors » de M. Richter, M. Hage-Ali, Z.T. Kuznicki et P. Siffert (Material Research Society, Symposium Proceedings, volume 302, 1993, pages 195 à 204).
[7] Article de O. Frisch (British Atomic Energy Report, BR-49-1944) .
[8] Article intitulé « Single-polarity charge sensing in ionization detectors using coplanar electrodes » de P.N. Luke (Applied Physic letter, n° 65, 1974, pages 2884 et suivantes).

## Revendications

1. Dispositif de détection de rayonnement ionisant comportant un bloc de matériau semi-conducteur de haute résistivité apte à détecter un signal électrique obtenu par l'interaction d'un rayonnement incident (10) avec le matériau semi-conducteur (11), muni d'une cathode (12) portée à un premier potentiel (V1) et d'une anode (13) portée à un second potentiel (V2), caractérisé en ce qu'il est muni d'au moins une grille (14) située entre la cathode (12) et l'anode (13), cette grille étant polarisée à un troisième potentiel (V3) supérieur au premier potentiel (V1) et peu inférieur au second (V2) de façon à ce que le signal généré entre la grille et l'anode soit indépendant du lieu d'interaction du photon avec le matériau détecteur, et en ce que la grille de Frisch ainsi composée est formée d'un seul bloc sans la réalisation de géométries de contact spécifiques ou de dépôt de diodes.

2. Dispositif selon la revendication 1, dans lequel la (ou les) grilles métalliques sont obtenues après insersion dans le creuset avant la cristallogénèse des semi-conducteurs, cette (ou ces) grille(s) se trouvant ainsi intégrée(s) dans le lingot avant sa croissance, une découpe spécifique du lingot en détecteurs et le dépôt de contact classique de part et d'autre des faces du détecteur permettant de réaliser une vraie grille de Frisch.

3. Dispositif selon la revendication 1, dans lequel la grille (14) est réalisée par la formation d'un peigne dont les parties supérieures sont portées au second potentiel (V2) et les parties inférieures au troisième potentiel (V3).

4. Dispositif selon la revendication 3, dans lequel une structure dentée est réalisée sur une des faces du bloc de matériau semi-conducteur, les lignes de contact polarisées au premier potentiel (V1) constituant un écran électrostatique aux lignes de contact polarisées au second potentiel (V2) lorsque les charges migrent de la cathode (12) à la grille (14), le signal mesuré correspondant à la migration des charges de la grille (14) à l'anode (13).

5. Dispositif selon l'une quelconque des revendications précédentes, qui s'applique à des détecteurs de rayonnements α, β, γ et X d'épaisseur comprise entre deux et dix millimètres.

6. Dispositif selon la revendication 6, dans lequel, pour les rayonnements X, le débit des photons est suffisamment lent pour que le détecteur puisse différencier chaque photon.
